Europäisches Patentamt

(19) European Patent Office

Office européen des brevets

(11) Publication number: **0 019 234**
**B1**

(12) **EUROPEAN PATENT SPECIFICATION**

(45) Date of publication of patent specification: **17.11.88**

(21) Application number: **80102572.7**

(22) Date of filing: **09.05.80**

(51) Int. Cl.⁴: **H 01 L 31/14, H 04 B 9/00**

(54) Semiconductor integrated circuit structure.

(30) Priority: **21.05.79 US 41115**

(43) Date of publication of application:
**26.11.80 Bulletin 80/24**

(45) Publication of the grant of the patent:
**17.11.88 Bulletin 88/46**

(84) Designated Contracting States:
**DE FR GB IT**

(56) References cited:
**FR-A-2 019 059**
**GB-A-1 137 915**
**US-A-4 065 729**
**IBM TECHNICAL DISCLOSURE BULLETIN, vol.
15, no. 9, february 1973, New York us, A.T.
HALPIN et al.: "Optical coupler/terminal", pp.
2760-2761**
**APPLIED PHYSICS LETTERS, vol. 34, no. 7,
April 1979, New York, US, I. URY et al.:
"Monolithic integration of an injection laser
and a metal semiconductor field effect
transistor", pp. 430-431**
**APPLIED PHYSICS LETTERS, vol. 35, no. 10, 15
november 1979, New York, US, M. YUST et al.:
"A monolithically integrated optical repeater",
pp. 795-797**

(73) Proprietor: **International Business Machines
Corporation
Old Orchard Road
Armonk, N.Y. 10504 (US)**

(72) Inventor: **Fang, Frank F.
1691 Cardinal Court
Yorktown Heights, New York 10598 (US)**
Inventor: **Hung, Roland Y.
RFD Green Tree Road
Yorktown Heights, New York 10598 (US)**

(74) Representative: **Bravi, Alfredo
IBM Italia S.p.A. Direzione Brevetti P.O.Box 137
I-20090 Segrate (Milano) (IT)**

## Description

The invention relates to an integrated semiconductor circuit chip including photoelectric receiver input means receiving signals from the outside of the chip and operable to convert optical into electrical signals, processing means operable to process electrical signals supplied thereto by the input means, and electrooptic driver output means transmitting signals to the outside of the chip derived from the electrical signals supplied thereto by the processing means and operable to convert electrical into optical signals, said processing means, input means and output means being physically separated from each other.

There have been many efforts in the art to improve the performance of the integrated circuits through use of semiconductor materials, such as gallium arsenide, having a high intrinsic carrier mobility, which translates into a high device density and a high switching speed. However, even though the on-chip performance of an integrated circuit is greatly improved, the signal communications to and from the chip introduce substantial propagation delays into the overall system. Use of optical communication techniques to reduce these delays has been known in the art.

US—A—4,041,475 describes a system employing optical communication techniques. This system, however, requires a complicated optical control system and is considerably expensive.

GB—A—1,137,915 describes a light detector, amplifier and electroluminescent diode configuration wherein the detector and amplifier are on one side of a silicon substrate and a feedthrough is provided to an electroluminescent zinc selenide cell on the opposite side of the substrate. This hybrid structure appears directed to light amplification and image conversion purposes rather than to the improvement of the communications characteristics of chips having broad processing capabilities.

US—A—4,065,702 describes a signal repeater for an optical waveguide. This repeater is a discrete structure that permits amplification and reshaping of a light pulse to transmit a substantially unmodified information content to the next repeater of a transmission line or to a receiving station. This repeater does not include processing means separated and operable independently from the input and output means, and accordingly does not permit a flexible logic processing of the received signals. In addition, this repeater appears to have limited usefulness in the exchange of signals among the chips of a data processing system.

The present invention, as set out in the claim, is intended to provide an improved chip which comprises interconnected circuit components, photoelectric converters providing input signals to said circuit components, and electrooptic converters providing output signals from said circuit components. Said converters provide optical communications both within the chip and between the chip and other elements of the overall circuit system, said communications being adaptable to fibre optic techniques.

One advantage offered by the invention is that it substantially increases the performance, and particularly the speed of operation, of a system employing integrated circuits. This derives from the fact that the new integrated circuit structure uses optical communications, and the optical drivers and receivers operate at approximately the same speed of the active circuit components of the structure.

Another advantage is that the invention permits a radical simplification in the integrated circuits, since a large scale integrated circuit structure incorporating the invention involves a single substrate rather than the conventional multilayers used in the art. This is achieved because the crossovers when done with optical guides are not burdened with concern for interference of electrical signals.

A further advantage is that the invention permits simple, reliable and economical optical communications with other integrated circuit structures. This is achieved by using optical guides, without the need for any optical control system.

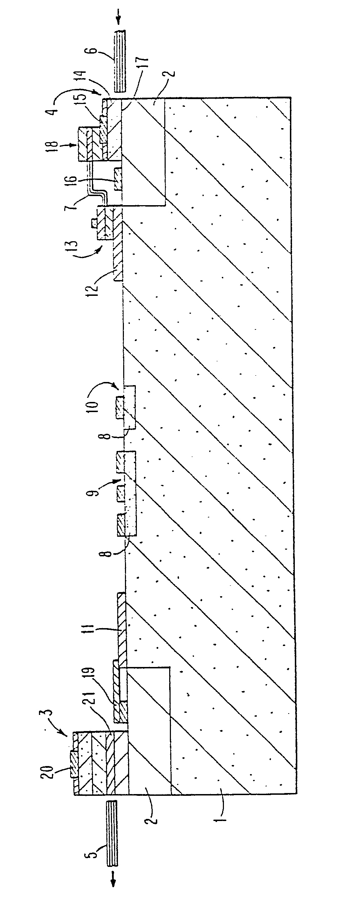

The drawing is an example, in cross-sectional view, of an integrated circuit structure according to the invention.

The figure shows a monolithically integrated semiconductor circuit chip having a substrate 1. The substrate 1 is made of a semiconductor material which has the capability of exhibiting electronic carrier properties with a high mobility, and at the same time has good optoelectronic conversion properties. In a preferred embodiment such material is gallium arsenide with light chromium doping, which not only satisfies these requirements, but also has the capability of exhibiting semi-insulating properties.

The substrate 1 supports an array of regions 2 having a N-type conductivity imparted by diffusion or ion implantation. These regions 2 receive the off-chip optoelectronic communications devices, which include a photoelectric receiver 4 and an electrooptic driver 3.

The photoelectric receiver 4 is a standard photodiode, comprised of a right-hand N-type region 2, and a P-type region 14. Electrical contacts 16 and 15 are made on said regions 2 and 14, respectively, and said regions have a light sensitive junction 17. The optical fibre 6 is adapted to transmit information from another chip entity, not shown, and is lined up to deliver a light signal to the junction 17.

The electrooptical driving capability of the integrated circuit chip of the invention is illustrated in connection with the driver 3, which is a solid state laser. A signal from the interface circuit 11 is applied to the driver 3 via the electrodes 19 and 20. A current flowing through the driver 3 produces in the region 21 a coherent light output which is transmitted, via the optical fibre 5 positioned to coincide with the region 21, to another chip, not shown.

As an illustrative example of the circuit components, N-type implanted regions 8 are shown to which ohmic and Schottky barrier contacts are formed, respectively producing field effect transistor 9 and diode 10. A plurality of circuit components like transistor 9 and diode 10 are arranged in an array and are connected by standard techniques known in the art. Interface circuits, symbolically set forth by lands 11 and 12, are provided to interconnect the array of circuit components represented by transistor 9 and diode 10 with the optical off-chip and on-chip communication apparatus, symbolically set forth as elements 3, 4 and 13, 18, in turn cooperating with optical fibres 5, 6 and 7.

The electrooptic driver 18, the photoelectric receiver 13 and the optical fibre 7 provide an illustration of the on-chip optical communication. The signal sensed at the electrical contact 15 of the receiver 4 is also applied to an electrooptic driver 18, which is similar in function to the driver 3. The driver 18 in turn via optical fibre 7 delivers a signal over the top of electrode 16 to the photoelectric receiver 13, which is similar to the receiver 4. This illustrates the on-chip crossover capability of the invention.

The properties of the gallium arsenide material are such that the circuit components 9, 10 achieve a high electric performance while the converters 3, 4, 13 and 18 achieve a high optoelectronic performance. Furthermore the resulting integrated circuit chip is fully satisfactory as far as device density and power dissipation are concerned. However it will be apparent to one skilled in the art that while the invention has been described with reference to a gallium arsenide substrate and MESFET (metal-semiconductor field effect transistor) technology, a variety of substrates and active devices may be used. For example, other semiconductor materials having both carrier mobility sufficient for the circuit components and conversion efficiency sufficient for the optoelectronic converters may be used in lieu of the gallium arsenide material. Furthermore junction components may be used in lieu of the MESFET components, and phototransistors and light emitting diodes may be used in lieu of the photodiodes and lasers, respectively.

## Claim

Integrated semiconductor circuit chip including photoelectric receiver input means (4) receiving signals from the outside of the chip and operable to convert optical signals into electrical signals, processing means comprising an array of electric circuit components (9, 10) and being operable to process electrical signals supplied thereto by said input means (4), and electrooptic driver output means (3) transmitting signals to the outside of the chip derived from the electrical signals supplied thereto by said processing means and operable to convert electrical signals into optical signals, the processing means, the input means (4) and the output means (3) being physically separated from each other, characterized in that said chip is a large scale monolithically integrated chip using a material having both high carrier mobility and good electrooptic and optoelectric conversion properties, and in that said chip is provided with at least two optical fibers (5, 6), one (6) of them being adjacent to and in optical coupling with the input means (4) and the other (5) with the output means (3), so as to optically connect the chip, when incorporated in a multichip system, with other two chips of the system.

## Patentanspruch

Chip mit integrierter Halbleiterschaltung, welcher photoelektrische Empfängereingangsmittel (4), welche Signale von außerhalb des Chips erhalten und so betreibbar sind, daß sie optische Signale in elektrische Signale umwandeln, Verarbeitungsmittel, welche eine Anordnung von elektrischen Schaltkreiskomponenten (9, 10) umfassen und so betreibbar sind, daß sie ihnen durch die Eingangsmittel (4) zugeführte elektrische Signale verarbeiten, und elektrooptische Treiberausgangsmittel (3), welche Signale, die von den ihnen durch die Verarbeitungsmittel zugeführten elektrischen Signalen hergeleitet sind, nach außerhalb des Chips übertragen und so betreibbar sind, daß sie elektrische Signale in optische Signale umwandeln, enthält, wobei die Verarbeitungsmittel, die Eingangsmittel (4) und die Ausgangsmittel (3) physisch voneinander getrennt sind, dadurch gekennzeichnet, daß der Chip ein monolithisch hochintegrierter Chip ist, welcher ein Material verwendet, das sowohl hohe Ladungsträgerbeweglichkeit als auch gute elektrooptische und optoelektrische Umwandlungseingenschaften aufweist, und daß der Chip mit wenigstens zwei optischen Fasern (5, 6) versehen ist, wobei eine (6) von diesen benachbart zu und in optischer Kopplung mit den Eingangsmitteln (4) und die andere (5) mit den Ausgangsmitteln (3) vorliegt, so daß der Chip bei Einbau in ein Multichipsystem mit anderen zwei Chips des Systems optisch verbunden wird.

## Revendication

Une puce de circuit intégré à semiconducteurs, comprenant des moyens d'entré photoélectriques récepteurs (4) recevant des signaux provenant de l'extérieur de la puce et pouvant fonctionner de manière à convertir des signaux optiques en signaux électriques, des moyens de traitement comprenant un réseau de composants de circuit électrique (9, 10) pouvant fonctionner de manière à traiter des signaux électriques qui leur sont appliqués par les moyens d'entrée (4), et des moyens de sortie de pilotage électrooptique (3) émettant vers l'extérieur de la puce des signaux obtenus à partir des signaux électriques qui leur sont appliqués par les moyens de traitement, et pouvant fonctionner de manière à convertir les signaux électriques en signaux opti-

ques, les moyens de traitement, les moyens d'entrée (4) et les moyens de sortie (3) étant physiquement distincts les uns des autres, caractérisée en ce que cette puce est une puce a intégration monolithique à grande échelle utilisant un matériau ayant à la fois une mobilité élevée des porteurs et de bonnes propriétés de conversion électro-optique et opto-électronique, et en ce que cette puce est pourvue d'au moins deux fibres optiques (5, 6), dont l'une (6) est adjacente aux moyens d'entrée (4) et optiquement couplée à ceux-ci, et dont l'autre (5) l'est aux moyens de sortie (3), de manière à relier optiquement la puce, lorsqu'elle est incorporée à un système à puces multiples, à deux autres puces du système.